# EUROPÄISCHE PATENTSCHRIFT

(11) **EP 3 870 980 B1**
(45) Veröffentlichungstag und Bekanntmachung des Hinweises auf die Patenterteilung: **17.04.2024**
(21) Anmeldenummer: 19769721.2
(22) Anmeldetag: 04.09.2019
(51) Int. Cl.: G01R 19/165

(54) **FENSTERKOMPARATOR SOWIE HANDWERKZEUGMASCHINE, ELEKTROWERKZEUG, LADEGERÄT UND/ODER HAUSHALTSGERÄT MIT EINEM DERARTIGEN FENSTERKOMPARATOR**
WINDOW COMPARATOR HAND-HELD POWER TOOL, ELECTRIC TOOL, CHARGING DEVICE, AND/OR DOMESTIC APPLIANCE COMPRISING SUCH A WINDOW COMPARATOR
COMPARATEUR À FENÊTRE AINSI QUE MACHINE-OUTIL PORTATIVE, OUTIL ÉLECTRIQUE, APPAREIL DE CHARGE ET/OU APPAREIL MÉNAGER COMPORTANT UN TEL COMPARATEUR À FENÊTRE

(30) Priorität: 22.10.2018 DE 102018218000
(43) Veröffentlichungstag der Anmeldung: 01.09.2021
(73) Patentinhaber: Robert Bosch GmbH, 70442 Stuttgart (DE)
(72) Erfinder: MACK, Juergen, 73035 Goeppingen (DE)
(86) Internationale Anmeldenummer: PCT/EP2019/073567
(87) Internationale Veröffentlichungsnummer: WO 2020/083547

(56) Entgegenhaltungen:
- JP-A- H06 104 706
- JP-A- 2001 078 482
- JP-A- 2004 301 709
- US-B1- 6 177 875
- MASAKAZU KATO ET AL: "LSI IMPLEMENTATION AND SAFETY VERIFICATION OF WINDOW COMPARATOR USED IN FAIL-SAFE MULTIPLE-VALUED LOGIC OPERATIONS", IEICE TRANSACTIONS ON ELECTRONICS, INSTITUTE OF ELECTRONICS, TOKYO, JP, Bd. E76 - C, Nr. 3, 1. März 1993 (1993-03-01), Seiten 419-427, XP000303984, ISSN: 0916-8524

## Beschreibung

### Stand der Technik

Die vorliegende Erfindung betrifft einen Fensterkomparator zur Überwachung einer Eingangsspannung, sowie eine Handwerkzeugmaschine, ein Elektrowerkzeug, ein Ladegerät und/oder ein Haushaltsgerät mit einem derartigen Fensterkomparator.

Aus dem Stand der Technik sind elektronische Fensterkomparatoren bzw. zweistufige Schwellwertdetektoren bzw. Amplituden-Detektorschaltungen zur Erfassung eines Spannungsbereichs sowohl in diskreter als auch in integrierter Schaltungstechnik in einer großen Variationsbreite vorbekannt.

Aus der DE 24 15 098 B2 ist eine diskret aufgebaute Amplituden-Detektorschaltung bzw. ein so genannter "Window-Detektor" bekannt. Diese Amplituden-Detektorschaltung weist eine erste Schwellwertschaltung auf, die auf eine Eingangsspannung anspricht und an ihrem Ausgang eine Ausgangsspannung liefert, die dem den Schwellwert einer ersten Spannung überschreitenden Teil der Eingangsspannung entspricht. Weiterhin ist eine zweite Schwellwertschaltung mit einem höheren Schwellwert als im Falle der ersten Schwellwertschaltung vorgesehen, die auf die Eingangsspannung anspricht und den Ausgang auf einen Bezugsspannungspunkt setzt, wenn die Eingangsspannung den Schwellwert der zweiten Schwellwertschaltung überschreitet. Dabei ist eine Rückkopplungsschaltung vorgesehen, welche auf die Spannung am Ausgang anspricht und eine Steuerspannung für die erste Schwellwertschaltung liefert, welche diese aus ihrem aktiven Zustand bringt, wenn der Ausgang durch die zweite Schwellwertschaltung auf einen Bezugspotentialpunkt gesetzt ist.

Aus der US 5,963,062 A ist ferner ein elektronischer Fensterkomparator bekannt.

Dieser Fensterkomparator enthält im Wesentlichen eine differentielle Schaltstufe mit einem Stromspiegel sowie einen nachgeschalteten Lastkreis. Weiterer Stand der Technik findet sich in MASAKAZU KATO ET AL: "LSI IMPLEMENTATION AND SAFETY VERIFICATION OF WINDOW COMPARATOR USED IN FAIL-SAFE MULTIPLE-VALUED LOGIC OPERATIONS",IEICE TRANSACTIONS ON ELECTRONICS, INSTITUTE OF ELECTRONICS, TOKYO, JP, Bd. E76 - C, Nr. 3, 1. März 1993, Seiten 419-427, in JP 2001 078482 A, JP H06 104706 A und JP 2004 301709 A.

### Offenbarung der Erfindung

Die vorliegende Erfindung betrifft einen Fensterkomparator zur Überwachung einer Eingangsspannung gemäß Anspruch 1.

Die Erfindung ermöglicht somit eine schaltungstechnisch einfache und kostengünstige Realisierung eines elektronischen Fensterkomparators, der zudem aufgrund seines geringen Strombedarfs insbesondere für akkubetriebene Mobilgeräte geeignet ist. Es finden ausschließlich diskrete bipolare Transistoren oder diskrete unipolare MOSFET's sowie mindestens ein diskreter ohmscher Widerstand Verwendung. Ausfallkritische Bauelemente, wie Elektrolytkondensatoren oder Spulen mit einem relativ geringen MTBF-Wert (Mean Time Between Failure) sind nicht erforderlich.

Weiterhin sind von den mindestens drei Transistoren mindestens zwei Transistoren npn-Transistoren und mindestens ein Transistor ist als komplementärer pnp-Transistor ausgebildet. Hierdurch kann ein minimalistischer Aufbau der Schaltung des elektronischen Fensterkomparators ermöglicht werden.

Zudem schaltet ein erster npn-Transistor, wenn die Eingangsspannung eine erste Spannungsschwelle in einem Bereich von etwa 0,6 V bis 1,2 V überschreitet. Somit kann einfach und unkompliziert eine Festlegung einer ersten Schaltschwelle ermöglicht werden.

Gemäß einer vorteilhaften Weiterbildung ist der pnp-Transistor solange eingeschaltet, bis die Eingangsspannung größer als eine zweite Spannungsschwelle ist, die einer Betriebsspannung des Fensterkomparators abzüglich einer Basis-Emitter-Spannung des pnp-Transistors entspricht. Hierdurch kann eine zweite Schaltschwelle des Fensterkomparators festgelegt werden. Bei den üblichen Transistorparametern von bipolaren Kleinsignal-Transistoren ergibt sich hiermit eine zweite Spannungsschwelle in der Größenordnung von beispielhaft 2,7 V, bei einer Betriebsspannung von beispielsweise 3,3V.

Bevorzugt ist zwischen der Basis und dem Emitter des pnp-Transistors ein Widerstand angeordnet. Hierdurch kann ermöglicht werden, dass der Transistor sich nicht ungewollt einschaltet bzw. sicher im ausgeschalteten Zustand verweilt. Vorzugsweise liegt die Betriebsspannung des Fensterkomparators in einem Bereich zwischen 3,0 V und 3,6 V. Infolgedessen ist der Fensterkomparator zur Überwachung einer Ladeelektronik von Lithium- oder Lithium-PolymerAkkumulatoren für akkubetriebene Geräte gut geeignet. Besonders bevorzugt liegt die Betriebsspannung in der Größenordnung von etwa 3,3 V, die der üblichen Zellenspannung von Lithium-Polymerakkumulatoren entspricht.

Bei einer Weiterbildung ist vorgesehen, dass ein zweiter npn-Transistor als ein Inverter für eine Kollektorspannung des ersten npn-Transistors wirkt und mittels des zweiten npn-Transistors zugleich eine Kollektorspannung des pnp-Transistors über einen siebten Widerstand gegen Masse ziehbar ist. Durch den mittels des zweiten npn-Transistors gebildeten Inverter, bzw. die Invertierstufe, werden die Ausgangsspannung des für die erste Schaltschwelle zuständigen ersten npn-Transistors und die Ausgangsspannung des für die zweite Schaltschwelle relevanten pnp-Transistors miteinander verknüpft und somit kann eine definierte Ausgangsspannung bzw. ein definiertes Ausgangssignal mit zwei Schaltzuständen bereitgestellt werden. In dem ersten Schaltzustand ist die Ausgangsspannung des Fensterkomparators ungefähr Null Volt bzw. liegt auf Masse, d.h. der Ausgang des Fensterkomparators ist im "Low"-Zustand. Die Ausgangsspannung des Fensterkomparators ist genau dann gleich der Betriebsspannung (zweiter Schaltzustand), wenn die Eingangsspannung zwischen den beiden Schaltschwellen liegt, ansonsten ist sie gleich Null Volt, das heißt der Ausgang des Fensterkomparators ist im "Low"-Zustand. In dem zweiten Schaltzustand des Fensterkomparators ist die Ausgangsspannung ungefähr gleich der Betriebsspannung, d.h. der Ausgang des Fensterkomparators ist im "High"-Zustand.

Weiterhin weist der Fensterkomparator einen mit einem betriebsspannungsseitigen ersten Widerstand und einem masseseitigen zweiten Widerstand gebildeten ersten Spannungsteiler auf, an dessen Spannungsabgriff eine zu überwachende Eingangsspannung anliegt, wobei der Spannungsabgriff über einen vierten Widerstand mit der Basis des ersten npn-Transistors sowie über einen dritten Widerstand mit der Basis des pnp-Transistors verbunden ist. Hierdurch liegen die Basis des ersten npn-Transistors und die Basis des komplementären pnp-Transistors auch bei unbeschaltetem Eingang des Fensterkomparators auf einem definierten Potential.

Zudem weist der Fensterkomparator einen mit einem betriebsspannungsseitigen fünften Widerstand und einem masseseitigen achten Widerstand gebildeten zweiten Spannungsteiler auf, dessen Spannungsabgriff mit dem Kollektor des ersten npn-Transistors und über einen neunten Widerstand mit der Basis des zweiten npn-Transistors verbunden ist. Hierdurch liegt die Basis des zweiten npn-Transistors auf einem definierten Potential.

Bei einer technisch vorteilhaften Fortbildung ist ein Kollektor des zweiten npn-Transistors mittels eines zehnten Widerstands gegen Masse geschaltet, wobei eine Kollektorspannung des zweiten npn-Transistors eine Ausgangsspannung des Fensterkomparators darstellt. Infolgedessen stellt sich ein definiertes Ausgangssignal bzw. eine definierte Ausgangsspannung ein.

Bevorzugt weisen der erste, zweite, fünfte, siebte und neunte Widerstand jeweils einen Wert von 1 kΩ auf, der dritte und vierte Widerstand weisen jeweils einen Wert von 47 kΩ auf, der sechste Widerstand weist einen Wert von 470 kΩ auf und der achte und zehnte Widerstand weisen jeweils einen Wert von 100 kΩ auf. Somit kann auf einfache Art und Weise ein Fensterkomparator für die meisten praxisrelevanten Anwendungsfälle mit geeigneten elektrischen Eigenschaften bereitgestellt werden.

Vorzugsweise sind die beiden npn-Transistoren jeweils mit einem Kleinsignaltransistor, insbesondere vom Typ 2N3904, und der eine pnp-Transistor mit einem Kleinsignaltransistor, insbesondere vom Typ 2N3906, gebildet. Infolgedessen ist eine kostengünstige, großserientaugliche Fertigung des einfachen, stromsparenden und zugleich robusten Fensterkomparators gegeben.

Darüber hinaus betrifft die Erfindung eine Handwerkzeugmaschine, ein Elektrowerkzeug, ein Ladegerät und/oder ein Haushaltsgerät mit mindestens einem Fensterkomparator gemäß der Erfindung. Hierdurch ist eine zuverlässige Erkennung von Fehlerzuständen in elektrischen Signalen von einer Vielzahl von elektrischen Geräten realisierbar.

### Kurze Beschreibung der Zeichnungen

Die Erfindung ist anhand von in den Zeichnungen dargestellten Ausführungsbeispielen in der nachfolgenden Beschreibung näher erläutert. Es zeigen:
- Fig. 1: eine schematische Ansicht eines Fensterkomparators nach Maßgabe des Standes der Technik,
- Fig. 2: ein Diagramm mit einem schematischen Eingangs- und Ausgangsspannungsverlauf des Fensterkomparators von Fig. 1 über die Zeit t,
- Fig. 3: ein beispielhaftes Schaltbild eines erfindungsgemäßen Fensterkomparators, und
- Fig. 4: ein Diagramm mit einem gemessenen Eingangs- und Ausgangsspannungsverlauf des Fensterkomparators von Fig. 3.

### Beschreibung der Ausführungsbeispiele

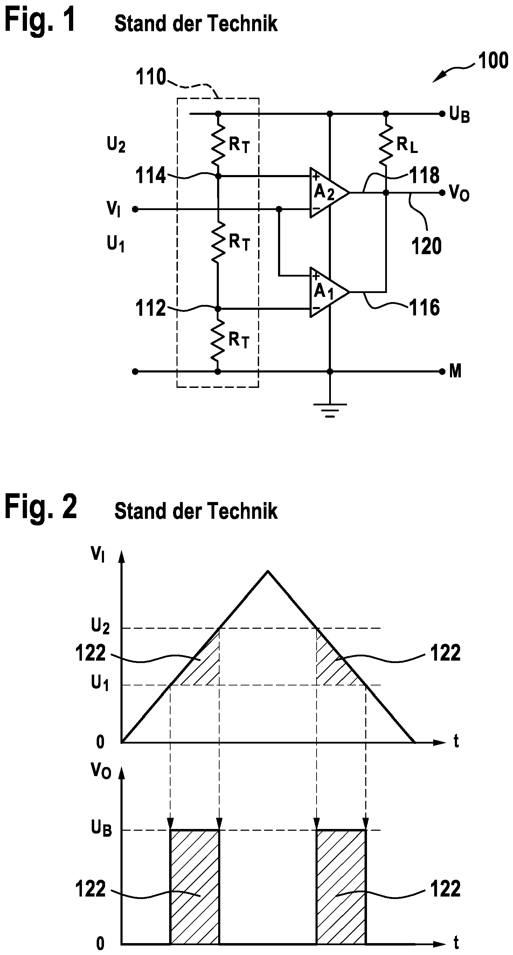

Fig. 1 zeigt einen aus dem Stand der Technik vorbekannten Fensterkomparator 100, der über einen ersten Operationsverstärker A₁, bzw. einen ersten Differenzverstärker, und einen zweiten Operationsverstärker A₂, bzw. einen zweiten Differenzverstärker, verfügt. Die beiden Operationsverstärker A_{1,} A₂ werden vorzugsweise mit einer unipolaren Betriebsspannung U_{B} beaufschlagt. Der erste Operationsverstärker A₁ ist illustrativ als ein nicht-invertierender Komparator geschaltet, während der zweite Operationsverstärker A₂ als ein invertierender Komparator geschaltet ist. Die beiden Operationsverstärker A₁ und A₂ sind in der Regel als eine komplexe, monolithisch integrierte Schaltung ausgeführt. Zwischen der Betriebsspannung U_{B} und Masse M ist ein Spannungsteiler 110 mit hier lediglich exemplarisch drei gleich großen, in Reihe liegenden ohmschen (Teiler-)Widerständen R_{T} geschaltet, so dass an einem masseseitigen ersten Spannungsabgriff 112 eine erste Spannung U, von vorzugsweise 1/3 U_{B} und an einem betriebsspannungsseitigen zweiten Spannungsabgriff 114 eine zweite Spannung U₂ von bevorzugt 2/3 U_{B} ansteht.

Die Eingangsspannung V_{I} des Fensterkomparators 100 liegt an einem positiven Eingang ("+"-Eingang) des ersten Operationsverstärkers A₁ sowie an einem negativen Eingang ("-"-Eingang) des zweiten Operationsverstärkers A₂ an. Die Ausgänge 116, 118 der beiden Operationsverstärker A_{1,2} sind parallel geschaltet und mittels eines Lastwiderstands R_{L}, bzw. eines s. g. "Pull-Up"-Widerstands, mit der Betriebsspannung U_{B} verbunden. Der erste Spannungsabgriff 112 ist mit dem negativen Eingang des ersten Operationsverstärkers A₁ verbunden, während der zweite Spannungsabgriff 114 mit dem positiven Eingang des zweiten Operationsverstärkers A₂ verbunden ist.

Ist die Eingangsspannung V_{I} kleiner als die erste Spannung U₁, so befindet sich der Ausgang 116 des ersten Operationsverstärkers A₁ in einem "Low"-Zustand, während der Ausgang 118 des zweiten Operationsverstärkers A₂ in einem "High"-Zustand ist, so dass die Ausgangsspannung Vo am Ausgang 120 des Fensterkomparators 100 bei ca. Null Volt bzw. auf Massepotential M liegt. Überschreitet die Eingangsspannung V_{I} die erste Spannung U₁, so schaltet der Ausgang 116 des ersten Operationsverstärkers A₁ ebenfalls in den "High"-Zustand - während der Ausgang 118 des zweiten Operationsverstärkers A₂ unverändert im "High"-Zustand verbleibt - und die Ausgangsspannung Vo des Ausgangs 120 des Fensterkomparators 100 erreicht praktisch die volle Höhe der Betriebsspannung UB.

Mit dem Begriff "Low"-Zustand wird im weiteren Fortgang der Beschreibung eine Spannung an einem Eingang oder an einem Ausgang von etwa Null Volt bzw. dem Massepotential bezeichnet. Im Gegensatz hierzu steht die Bezeichnung "High"-Zustand für eine Spannung an einem Eingang oder an einem Ausgang in der Größenordnung der Betriebsspannung U_{B}.

Übersteigt die Eingangsspannung V_{I} schließlich auch die zweite Spannung U₂, so verbleibt der Ausgang 116 des ersten Operationsverstärkers A₁ weiterhin im "High"-Zustand, während der Ausgang 118 des zweiten Operationsverstärkers A₂ in den "Low"-Zustand umschaltet und der Ausgang 120 des Fensterkomparators 100 in den Low-Zustand schaltet bzw. die Ausgangsspannung Vo ungefähr das Potential der Masse M annimmt. Nur wenn die Eingangsspannung V_{I} des Fensterkomparators 100 zwischen den beiden Spannungen U₁, U₂ liegt - die eine erste und eine zweite Spannungsschwelle darstellen - ist die Ausgangsspannung Vo des Fensterkomparators 100 nahezu gleich der Betriebsspannung U_{B}, ansonsten ist die Ausgangsspannung Vo ungefähr Null Volt.

Fig. 2 zeigt einen beispielhaften Spannungsverlauf des Fensterkomparators 100 von Fig. 1, der exemplarisch mit einer positiven periodischen und dreieckförmigen Eingangsspannung V_{I} beaufschlagt wird. Die Ausgangsspannung Vo erreicht nur dann die Betriebsspannung U_{B}, bzw. der Ausgang des Fensterkomparators 100 schaltet nur dann in den "High"-Zustand, wenn die Eingangsspannung V_{I} in einem (Spannungs-)Fenster 122 zwischen der ersten und der zweiten Spannung U₁, U₂ - hier also zwischen 1/3 U_{B} und 2/3 U_{B} - liegt. Andernfalls liegt die Ausgangsspannung Vo auf Null Volt, bzw. der Ausgang des Fensterkomparators nimmt den "Low"-Zustand ein.

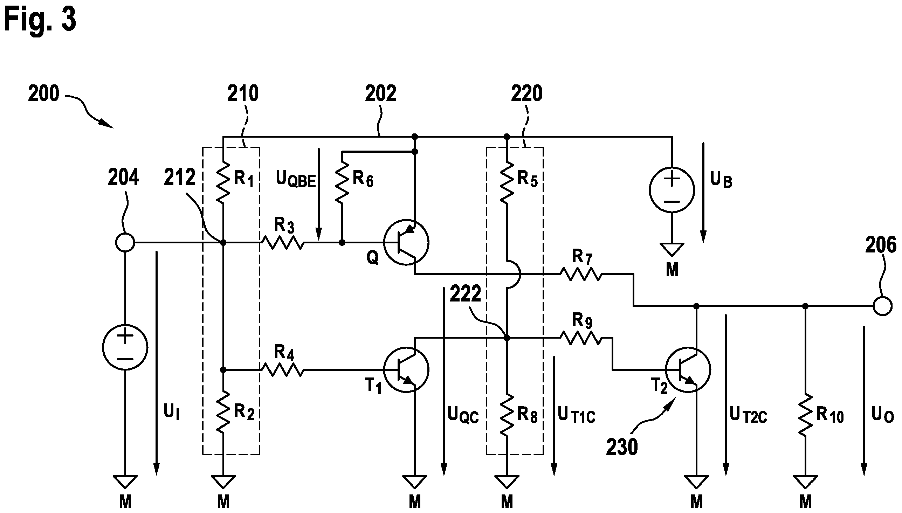

Fig. 3 zeigt einen erfindungsgemäßen Fensterkomparator 200 mit einem diskreten, spulen- und kondensatorfreien Aufbau, der mindestens drei Transistoren sowie mindestens einen ohmschen Widerstand umfasst. Illustrativ weist der Fensterkomparator 200 zwei bipolare npn-Transistoren T₁, T₂, einen bipolaren komplementären pnp-Transistor Q sowie beispielhaft zehn ohmsche Widerstände R₁ - R₁₀ auf. Eine weitere beispielhafte Ausgestaltung der Schaltung des Fensterkomparators 200 erfordert eine Minimalzahl von drei Transistoren sowie bevorzugt mindestens sechs ohmsche Widerstände. Es wird jedoch darauf hingewiesen, dass der Fensterkomparator 200 auch eine beliebig größere Anzahl an Widerständen aufweisen kann.

Eine Betriebsspannung U_{B} zwischen der Masse M und einer Plusschiene 202 liegt vorzugsweise in einem Bereich zwischen 3,0 V und 3,6 V und ist damit in Verbindung mit dem äußerst geringen Strombedarf der Schaltung des Fensterkomparators 200 ideal für akkubetriebene Mobilgeräte geeignet. Der Spannungsbereich von U_{B} ist bevorzugt insbesondere für die Überwachung einer Ladeelektronik von Lithium-Akkus und Lithium-Polymer-Akkus geeignet.

Die Schaltung des Fensterkomparators 200 weist bevorzugt einen ersten Spannungsteiler 210 auf, der mit einem betriebsspannungsseitigen ersten Widerstand R₁ und mit einem masseseitigen zweiten Widerstand R₂ aufgebaut ist. An einem Eingang 204 des Fensterkomparators 200 liegt vorzugsweise eine von diesem zu überwachende Eingangsspannung U_{I}, bzw. ein beliebiges elektrisches Signal, an. Der Eingang 204 des Fensterkomparators 200 ist bevorzugt mit einem Spannungsabgriff 212 des ersten Spannungsteilers 210 elektrisch verbunden. Weiterhin ist der Spannungsabgriff 212 vorzugsweise über einen dritten Widerstand R₃ mit der Basis des einzigen komplementären pnp-Transistors Q, sowie über einen vierten Widerstand R₄ mit der Basis des ersten npn-Transistors T₁ verbunden. Zwischen der Basis und dem Emitter des komplementären pnp-Transistors Q ist bevorzugt ein Widerstand R₆ vorgesehen. Der Widerstand R₆ dient - ebenso wie die weiteren vier ohmschen Widerstände R₁, R₄, R₈, R₉ - vorzugsweise zur Gewährleistung einer sicheren Abschaltung, so dass lediglich Strom fließt, wenn dies auch vorgesehen ist.

Die Schaltung des Fensterkomparators 200 verfügt ferner vorzugsweise über einen zweiten Spannungsteiler 220, der mit einem betriebsspannungsseitigen fünften Widerstand R₅ und einem masseseitigen achten Widerstand R₈ gebildet ist. Ein Spannungsabgriff 222 des zweiten Spannungsteilers 220 ist vorzugsweise mit dem Kollektor des ersten npn-Transistors T₁ und über einen neunten Widerstand R₉ mit der Basis des zweiten npn-Transistors T₂ verbunden. Der zweite npn-Transistor T₂ fungiert als ein Inverter 230 für eine Kollektorspannung U_{T1C} des ersten npn-Transistors T₁. Mittels des zweiten npn-Transistors T₂ ist zugleich eine Kollektorspannung U_{QC} des pnp-Transistors Q über einen siebten Widerstand R₇ gegen Masse M ziehbar. Ein Kollektor des zweiten npn-Transistors T₂ ist mittels eines zehnten Widerstands R₁₀ gegen Masse M geschaltet, wobei eine Kollektorspannung U_{T2C} des zweiten npn-Transistors T₂ eine Ausgangsspannung Uo des Fensterkomparators 200 darstellt.

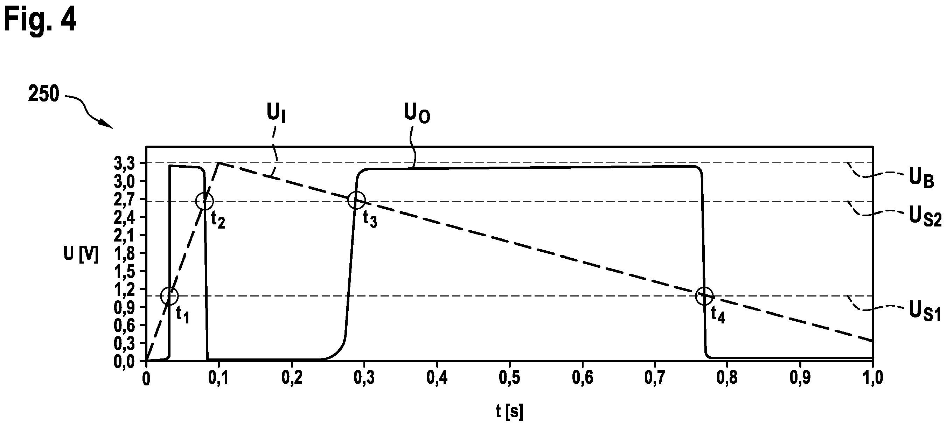

Der erste npn-Transistor T₁ schaltet vorzugsweise, wenn die Eingangsspannung U_{I} eine erste Spannungsschwelle (Us, in Fig. 4) in einem Bereich von hier beispielhaft etwa 0,6 V bis 1,2 V überschreitet. Der komplementäre pnp-Transistor Q bleibt dabei bevorzugt solange eingeschaltet, bis die Eingangsspannung U_{I} größer als eine zweite Spannungsschwelle (U_{S2} in Fig. 4) wird, die einer Betriebsspannung U_{B} des Fensterkomparators 200 abzüglich einer Basis-Emitter-Spannung U_{QBE} des komplementären pnp-Transistors Q entspricht. Abweichend von der hier lediglich exemplarisch gezeigten Schaltung des Fensterkomparators 200 können auch mindestens zwei komplementäre pnp-Transistoren und mindestens ein npn-Transistor vorgesehen sein, woraus dann ein im Wesentlichen gespiegelter Schaltungsaufbau resultiert. Weiterhin kann anstelle der hier nur beispielhaft gezeigten Emitter-Schaltung eine Kollektor- oder Basis-Schaltung der mindestens drei Transistoren vorgesehen sein.

Der erste, zweite, fünfte, siebte und neunte Widerstand, d.h. R₁, R₂, R₅, R₇, R₉, weisen jeweils vorzugsweise einen Wert von 1 kΩ auf. Der dritte und vierte Widerstand R₃, R₄ sind bevorzugt jeweils mit einem Wert von 47 kΩ bemessen. Der sechste Widerstand R₆ hat bevorzugt einen Wert von 470 kΩ und ein achter und zehnter Widerstand R₈, R₁₀ sind jeweils 100 kΩ groß. Hiervon abweichende Dimensionierungen der Widerstände R₁ - R₁₀ können in Abhängigkeit von den an den Fensterkomparator 200 gestellten Anforderungen erforderlich sein. Es wird darauf hingewiesen, dass die illustrativ zehn Widerstände auch jeweils durch mehrere Widerstände ausgebildet sein können, sodass z.B. der Widerstand R₁, der beispielhaft einen Wert von 1 kΩ aufweist, auch durch zwei Widerstände mit einem Wert von 0,5 kΩ ausgebildet sein kann, usw.

Bevorzugterweise sind die beiden npn-Transistoren T₁, T₂ jeweils mit einem Kleinsignaltransistor, insbesondere vom Typ 2N3904, gebildet und der eine komplementäre pnp-Transistor Q ist ebenfalls mit einem Kleinsignaltransistor, insbesondere vom Typ 2N3906, gebildet. Zur weiteren Reduktion des Strombedarfs des Fensterkomparators 200 können beispielsweise unipolare MOSFET's unter Verwendung mindestens eines komplementären MOSFET's zur Anwendung kommen. Der erfindungsgemäße Fensterkomparator 200 eignet sich optimal zur Erkennung von Fehlerzuständen elektrischer Signale aller Art. Dies ist vorteilhaft, denn falls beispielsweise ein elektrisches Signal nur auf den "High"-Zustand oder den "Low"-Zustand hin überprüft wird, so ist es bereits bei einfachen und naheliegenden Bauteildefekten für einen nachfolgenden Schaltungsteil nicht mehr erkennbar, ob ein Fehlerfall vorliegt oder nicht.

Betrachtet man beispielsweise einen mit zwei ohmschen Widerständen gebildeten Spannungsteiler, so ergeben sich bei der Fehleranalyse zwei mögliche Fehlerzustände. Der Spannungsabgriff des zu überwachenden Spannungsteilers kann in einem Fehlerfall entweder die Spannung von Null Volt aufweisen oder aber auf dem Niveau der Betriebsspannung liegen. Ein derartiger Fehlerfall kann z.B. durch eine hochohmige Lötstelle, einen Drahtbruch, einen durchgebrannten und damit hochohmigen Widerstand, einen Kurzschluss innerhalb eines (Draht-) Widerstands oder dergleichen verursacht werden. Mittels des Fensterkomparators 200 lassen sich derartige elektrische Fehlerzustände zuverlässig detektieren, da der Ausgang 206 des Fensterkomparators 200 in den "High"-Zustand schaltet, wenn die Eingangsspannung U_{I} im Intervall zwischen der ersten und zweiten Spannungsschwelle liegt und somit keiner der vorstehend genannten Fehlerfälle gegeben ist. Ist hingegen die Eingangsspannung U_{I} kleiner als die erste Spannungsschwelle oder größer als die zweite Spannungsschwelle, so schaltet der Ausgang 206 des Fensterkomparators 200 in den "Low"-Zustand, was auf das Vorliegen eines der obigen Fehlerfälle hinweist.

Der erfindungsgemäße Fensterkomparator 200 ist somit für unterschiedlichste Anwendungen im Rahmen einer Überwachung von elektrischen Signalen, wie zum Beispiel bei Messungen von physikalischen Größen, insbesondere von Temperatur, Feuchtigkeit, Luftdruck, Weg, Winkel, Licht, Drehzahl oder Geschwindigkeit etc. geeignet. Durch den minimalen Strombedarf des Fensterkomparators 200 ist dieser darüber hinaus zur Signalüberwachung bei mobilen, ackubetriebenen Geräten, insbesondere Handwerkzeugmaschinen und Elektrowerkzeugen, prädestiniert.

Besonders bevorzugt kann der Fensterkomparator 200 bei einer Elektronik zur Drehzahlregelung sowie zur Sensorüberwachung eingesetzt werden. Somit lässt sich überprüfen, ob die elektrische Anbindung des Sensors an eine nachgeschaltete Elektronik fehlerfrei ist, das heißt ob der Sensor elektrisch noch "vorhanden", insbesondere nicht abgerissen und/oder kurzgeschlossen ist und somit keine verfälschten Sensorsignale liefert. Ebenso lassen sich Drahtbrüche und/oder kalte Lötstellen eines mit Hilfe des Fensterkomparators 200 überwachten Sensors detektieren. Weiterhin ist eine Verwendung des Fensterkomparators 200 im Bereich der Spannungssignalüberwachung bei Ladegeräten und Haushaltsgeräten geeignet. Ferner kann der Fensterkomparator 200 für Staubsauger angewandt werden, um eine gewählte Leistungsstufe bezüglich der Saugleistung, wie z.B. schwach, mittel, stark, zu überwachen, d.h. um insbesondere festzustellen, ob eine vom Benutzer gewählte Leistungsstufe auch dauerhaft beibehalten wird. Fig. 4 zeigt ein dem Fensterkomparator 200 von Fig. 3 zugeordnetes Eingangs- und Ausgangsspannungsverlauf-Diagramm 250. Auf der Abszisse des Diagramms 250 ist die Zeit t in Sekunden aufgetragen, während die Ordinate die Spannung U in Volt in einem Intervall von etwa Null Volt bis etwa beispielhaft 3,3 Volt zeigt. Eine an den Fensterkomparator von Fig. 3 versuchsweise angelegte Eingangsspannung U_{I} weist einen näherungsweise keilförmigen bzw. sägezahnförmigen Verlauf über die Zeit t auf und ist mit einer punktierten Linie dargestellt. Die Eingangsspannung U_{I} weist aufgrund ihres Sägezahncharakters in einem Intervall zwischen t₁ und t₂ eine relativ hohe Anstiegsgeschwindigkeit und in einem Bereich zwischen t₃ und t₄ eine in Relation dazu geringe Abfallgeschwindigkeit auf.

Die beiden Spannungsschwellen U_{S1}, U_{S2} des Fensterkomparators 200 sowie die Betriebsspannung U_{B} des Fensterkomparators 200 sind jeweils mit einer gestrichelten Linie veranschaulicht. Die erste Spannungsschwelle U_{S1} beträgt hier lediglich exemplarisch etwa 1,1 Volt, wohingegen die zweite Spannungsschwelle U_{S2} bei etwa 2, 7 Volt liegt. Die Versorgungs- bzw. Speisespannung des Fensterkomparators 200 liegt vorzugsweise bei 3,3 Volt.

Bis zu dem Zeitpunkt t₁ (illustrativ und lediglich beispielhaft 0,033 s) ist die Eingangsspannung U_{I} an dem Eingang des Fensterkomparators 200 unter der ersten Spannungsschwelle U_{S1} und die Ausgangsspannung Uo ist gleich Null. Im ersten Zeitpunkt t₁ erreicht die Eingangsspannung U_{I} die erste Spannungsschwelle U_{S1} und der Ausgang des Fensterkomparators 200 schaltet in den "High"-Zustand, d.h. die Ausgangsspannung Uo am Ausgang des Fensterkomparators 200 erreicht nahezu die Betriebsspannung U_{B} des Fensterkomparators 200. Im Zeitpunkt t₂ (illustrativ und lediglich beispielhaft 0,083 s) übersteigt die Eingangsspannung U_{I} die zweite Spannungsschwelle U_{S2}, wodurch der Ausgang des Fensterkomparators 200 wieder in den "Low"-Zustand zurückschaltet und die Ausgangsspannung Uo näherungsweise auf Massepotenzial abfällt. Im Zeitpunkt t₃ (illustrativ und lediglich beispielhaft 0,290 s) fällt die Eingangsspannung U_{I} wieder unter die zweite Spannungsschwelle U_{S2}, so dass der Ausgang des Fensterkomparators 200 wieder in den "High"-Zustand schaltet und die Ausgangsspannung Uo ungefähr den Wert der Betriebsspannung von 3,3 Volt erreicht. Im Zeitpunkt t₄ (illustrativ und lediglich beispielhaft 0,770 s) unterschreitet die Eingangsspannung U_{I} am Eingang des Fensterkomparator 200 die erste Spannungsschwelle U_{S1}, wodurch der Ausgang des Fensterkomparators 200 in den "Low"-Zustand versetzt wird und sich eine Ausgangsspannung Uo am Ausgang des Fensterkomparators von etwa Null Volt ergibt.

Ferner ist aus dem Diagramm 250 ersichtlich, dass eine Flankensteilheit der Ausgangsspannung Uo weitestgehend unabhängig von der Anstiegs- und Abfallgeschwindigkeit der sägezahnförmigen Eingangsspannung U_{I} ist, sodass für nachfolgende elektronische Schaltungsteile des Fensterkomparators 200 eine exakt definierte und zuverlässig auswertbare Ausgangsspannung Uo als Ausgangssignal des Fensterkomparators 200 zur Verfügung steht.

## Patentansprüche

1. Fensterkomparator (200) mit einer Schaltung zur Überwachung einer Eingangsspannung (U_{I}), wobei die Schaltung einen diskreten, spulen- und kondensatorfreien Aufbau aufweist, wobei der Fensterkomparator (200) mindestens drei Transistoren sowie mindestens sechs ohmsche Widerstände (R₁ - R₁₀) umfasst,
**dadurch gekennzeichnet, dass** ein Eingang (204) des Fensterkomparators (200) mit einem Spannungsabgriff (212) eines ersten Spannungsteilers (210) elektrisch verbunden ist, und der Spannungsabgriff (212) über einen ersten Widerstand (R₃) mit einer Basis eines einzigen komplementären pnp-Transistors (Q), sowie über einen zweiten Widerstand (R₄) mit einer Basis eines ersten npn-Transistors (T₁) verbunden ist,
und wobei ein Spannungsabgriff (222) eines zweiten Spannungsteilers (220) mit einem Kollektor des ersten npn-Transistors (T₁) und über einen dritten Widerstand (R₉) mit der Basis eines zweiten npn-Transistors (T₂) verbunden
ist,
und wobei ein Kollektor des zweiten npn-Transistors (T₂) mittels eines vierten Widerstands (R₁₀) gegen Masse (M) geschaltet ist, wobei eine Kollektorspannung (U_{T2C}) des zweiten npn-Transistors (T₂) eine Ausgangsspannung (Uo) des Fensterkomparators (200) darstellt,
wobei der erste npn-Transistor (T₁) dazu ausgebildet ist, bei einem Überschreiten der Eingangsspannung (U_{I}) einer ersten Spannungsschwelle (U_{S1}) in einem Bereich von etwa 0,6 V bis 1,2 V zu schalten,
und wobei der pnp-Transistor (Q) dazu ausgebildet ist, eingeschaltet zu sein, bis die Eingangsspannung (U_{I}) größer als eine zweite Spannungsschwelle (U_{S2}) ist, die einer Betriebsspannung (U_{B}) des Fensterkomparators (200) abzüglich einer Basis-Emitter-Spannung (U_{QBE}) des pnp-Transistors (Q) entspricht.

2. Fensterkomparator nach Anspruch 1, **dadurch gekennzeichnet, dass** zwischen der Basis und dem Emitter des pnp-Transistors (Q) ein fünfter Widerstand (R₆) angeordnet ist.

3. Fensterkomparator nach einem der vorhergehenden Ansprüche, **dadurch gekennzeichnet, dass** die Betriebsspannung (U_{B}) des Fensterkomparators (200) in einem Bereich zwischen 3,0 V und 3,6 V liegt.

4. Fensterkomparator nach Anspruch 2 oder 3, **dadurch gekennzeichnet, dass** ein zweiter npn-Transistor (T₂) als ein Inverter (230) für eine Kollektorspannung (U_{T1C}) des ersten npn-Transistors (T₁) wirkt und mittels des zweiten npn-Transistors (T₂) zugleich eine Kollektorspannung (U_{QC}) des pnp-Transistors (Q) über einen sechsten Widerstand (R₇) gegen Masse (M) ziehbar ist, wobei der sechste Widerstand (R₇) zwischen dem Kollektor des pnp-Transistors (Q) und dem Kollektor des zweiten npn-Transistors (T₂) angeordnet ist.

5. Fensterkomparator nach Anspruch 4, **dadurch gekennzeichnet, dass** der Fensterkomparator (200) einen mit einem betriebsspannungsseitigen Widerstand (R₁) und einem masseseitigen Widerstand (R₂) gebildeten ersten Spannungsteiler (210) aufweist, an dessen Spannungsabgriff (212) eine zu überwachende Eingangsspannung (U_{I}) anliegt.

6. Fensterkomparator nach Anspruch 5, **dadurch gekennzeichnet, dass** der Fensterkomparator (200) einen mit einem betriebsspannungsseitigen weiteren Widerstand (R₅) und einem masseseitigen weiteren Widerstand (R₈) gebildeten zweiten Spannungsteiler (220) aufweist.

7. Fensterkomparator nach einem der vorhergehenden Ansprüche, **dadurch gekennzeichnet, dass** die beiden npn-Transistoren (T_{1,2}) mit einem Kleinsignaltransistor, insbesondere vom Typ 2N3904, und der eine pnp-Transistor (Q) mit einem Kleinsignaltransistor, insbesondere vom Typ 2N3906, gebildet sind.

8. Handwerkzeugmaschine, Elektrowerkzeug, Ladegerät und/oder Haushaltsgerät mit mindestens einem Fensterkomparator (200) nach einem der vorhergehenden Ansprüche.

## Claims

1. Window comparator (200) having a circuit for monitoring an input voltage (U_{I}), wherein the circuit has a discrete, coil-free and capacitor-free design, wherein the window comparator (200) comprises at least three transistors and at least six ohmic resistors (R₁ - R₁₀), **characterized in that** an input (204) of the window comparator (200) is electrically connected to a voltage tap (212) of a first voltage divider (210), and the voltage tap (212) is connected via a first resistor (R₃) to a base of a single complementary pnp transistor (Q), and via a second resistor (R₄) to a base of a first npn transistor (T₁),
and wherein a voltage tap (222) of a second voltage divider (220) is connected to a collector of the first npn transistor (T₁) and via a third resistor (R₉) to the base of a second npn transistor (T₂),
and wherein a collector of the second npn transistor (T₂) is connected by means of a fourth resistor (R₁₀) to earth (M), wherein a collector voltage (U_{T2C}) of the second npn transistor (T₂) constitutes an output voltage (U_{O}) of the window comparator (200), wherein the first npn transistor (T₁) is designed to switch when the input voltage (U_{I}) exceeds a first voltage threshold (U_{S1}) in a range from about 0.6 V to 1.2 V,
and wherein the pnp transistor (Q) is designed to be switched on until the input voltage (U_{I}) is greater than a second voltage threshold (U_{S2}) which corresponds to an operating voltage (U_{B}) of the window comparator (200) minus a base-emitter voltage (U_{QBE}) of the pnp transistor (Q).

2. Window comparator according to Claim 1, **characterized in that** a fifth resistor (R₆) is arranged between the base and the emitter of the pnp transistor (Q).

3. Window comparator according to either of the preceding claims, **characterized in that** the operating voltage (U_{B}) of the window comparator (200) is in a range between 3.0 V and 3.6 V.

4. Window comparator according to Claim 2 or 3, **characterized in that** a second npn transistor (T₂) acts as an inverter (230) for a collector voltage (U_{T1C}) of the first npn transistor (T₁) and by means of the second npn transistor (T₂) at the same time a collector voltage (U_{QC}) of the pnp transistor (Q) is able to be drawn to earth (M) via a sixth resistor (R₇), wherein the sixth resistor (R₇) is arranged between the collector of the pnp transistor (Q) and the collector of the second npn transistor (T₂).

5. Window comparator according to Claim 4, **characterized in that** the window comparator (200) has a first voltage divider (210) formed with an operating-voltage-side resistor (R₁) and an earth-side resistor (R₂), an input voltage (U_{I}) to be monitored being applied to the voltage tap (212) of said voltage divider.

6. Window comparator according to Claim 5, **characterized in that** the window comparator (200) has a second voltage divider (220) formed with an operating-voltage-side further resistor (R₅) and an earth-side further resistor (R₈).

7. Window comparator according to one of the preceding claims, **characterized in that** the two npn transistors (T_{1,2}) are formed with a small-signal transistor, in particular of the 2N3904 type, and the one pnp transistor (Q) is formed with a small-signal transistor, in particular of the 2N3906 type.

8. Hand-held power tool, electric tool, charging device and/or domestic appliance having at least one window comparator (200) according to one of the preceding claims.

## Revendications

1. Comparateur à fenêtre (200) comprenant un circuit destiné à surveiller une tension d'entrée (U_{I}), le circuit présentant une structure discrète, sans bobine ni condensateur, le comparateur à fenêtre (200) comprenant au moins trois transistors ainsi qu'au moins six résistances ohmiques (R₁ - R₁₀),
**caractérisé en ce qu'**une entrée (204) du comparateur à fenêtre (200) est reliée électriquement à une prise de tension (212) d'un premier diviseur de tension (210), et la prise de tension (212) est reliée par le biais d'une première résistance (R₃) à une base d'un unique transistor PNP complémentaire (Q), ainsi que par le biais d'une deuxième résistance (R₄) à une base d'un premier transistor NPN (T₁),
et une prise de tension (222) d'un deuxième diviseur de tension (220) étant reliée à un collecteur du premier transistor NPN (T₁) et à la base d'un deuxième transistor NPN (T₂) par le biais d'une troisième résistance (R₉), et un collecteur du deuxième transistor NPN (T₂) étant connecté à la masse (M) au moyen d'une quatrième résistance (R₁₀), une tension de collecteur (U_{T2C}) du deuxième transistor NPN (T₂) représentant une tension de sortie (U_{O}) du comparateur à fenêtre (200), le premier transistor NPN (T₁) étant configuré pour commuter lorsque la tension d'entrée (U_{I}) dépasse un premier seuil de tension (U_{S1}) dans une plage d'environ 0,6 V à 1,2 V,
et le transistor PNP (Q) étant configuré pour être passant jusqu'à ce que la tension d'entrée (U_{I}) soit supérieure à un deuxième seuil de tension (U_{S2}), qui correspond à une tension de service (U_{B}) du comparateur à fenêtre (200) moins une tension base-émetteur (U_{QBE}) du transistor PNP (Q).

2. Comparateur à fenêtre selon la revendication 1, **caractérisé en ce qu'**une cinquième résistance (R₆) est disposée entre la base et l'émetteur du transistor PNP (Q).

3. Comparateur à fenêtre selon l'une des revendications précédentes, **caractérisé en ce que** la tension de service (U_{B}) du comparateur à fenêtre (200) est comprise dans une plage de 3,0 V à 3,6 V.

4. Comparateur à fenêtre selon la revendication 2 ou 3, **caractérisé en ce qu'**un deuxième transistor NPN (T₂) agit comme un inverseur (230) pour une tension de collecteur (U_{T1C}) du premier transistor NPN (T₁) et, au moyen du deuxième transistor NPN (T₂), une tension de collecteur (U_{QC}) du transistor PNP (Q) peut être tirée en même temps à la masse (M) par le biais d'une sixième résistance (R₇), la sixième résistance (R₇) étant disposée entre le collecteur du transistor PNP (Q) et le collecteur du deuxième transistor NPN (T₂).

5. Comparateur à fenêtre selon la revendication 4, **caractérisé en ce que** le comparateur à fenêtre (200) possède un premier diviseur de tension (210) formé par une résistance côté tension de service (R₁) et une résistance côté masse (R₂), à la prise de tension (212) duquel est appliquée une tension d'entrée (U_{I}) à surveiller.

6. Comparateur à fenêtre selon la revendication 5, **caractérisé en ce que** le comparateur à fenêtre (200) possède un deuxième diviseur de tension (220) formé par une résistance supplémentaire côté tension de service (R₅) et une résistance supplémentaire côté masse (R₈).

7. Comparateur à fenêtre selon l'une des revendications précédentes, **caractérisé en ce que** les deux transistors NPN (T_{1, 2}) sont formés par un transistor à faible signal, notamment du type 2N3904, et l'un des transistors PNP (Q) par un transistor à faible signal, notamment du type 2N3906.

8. Machine-outil portative, outil électrique, chargeur et/ou appareil ménager comprenant au moins un comparateur de fenêtre (200) selon l'une des revendications précédentes.
